# FASCICULE DE BREVET EUROPEEN

(11) **EP 1 292 975 B1**
(45) Date de publication et mention de la délivrance du brevet: **21.03.2007**
(21) Numéro de dépôt: 01945456.0
(22) Date de dépôt: 15.06.2001
(51) Int. Cl.: H01L 21/762

(54) **PROCEDE DE FABRICATION DE SUBSTRATS ET SUBSTRATS OBTENUS PAR CE PROCEDE**
VERFAHREN ZUR HERSTELLUNG VON SUBSTRATEN UND DADURCH HERGESTELLTE SUBSTRATE
METHOD FOR MAKING SUBSTRATES AND RESULTING SUBSTRATES

(30) Priorité: 16.06.2000 FR 0007755
(43) Date de publication de la demande: 19.03.2003
(73) Titulaire: S.O.I.Tec Silicon on Insulator Technologies, 38190 Bernin (FR)
(72) Inventeur: AUBERTON-HERVE, André, 38240 MEYLAN (FR)
(74) Mandataire: Bomer, Françoise Marie
(86) Numéro de dépôt international: PCT/FR2001/001876
(87) Numéro de publication internationale: WO 2001/097282

(56) Documents cités:
- FR-A- 2 681 472
- US-A- 5 298 449

## Description

L'invention concerne le domaine des procédés de fabrication de substrats, notamment pour l'optique, l'électronique ou l'optoélectronique. Plus précisément, l'invention concerne des procédés de fabrication de substrats dans lesquels un élément de matériau utile est transféré sur un support.

Un but de l'invention est de diminuer le prix de revient de tels substrats tout en obtenant un bon collage entre le support et l'élément de matériau utile.

Ce but est atteint selon l'invention, grâce à un procédé de fabrication de substrats, notamment pour l'optique, l'électronique ou l'optoélectronique, comprenant une opération de collage d'un élément utile d'un premier matériau sur une face d'un support, comportant un deuxième matériau, caractérisé par le fait
- qu'il comprend en outre, préalablement à l'opération de collage, une opération de dépôt d'un matériau amorphe, sur la face du support constituée du deuxième matériau et destinée à recevoir l'élément constitué du premier matériau, ou sur la face de l'élément utile constitué du premier matériau et destinée à être collée sur le support, et par le fait
- que le deuxième matériau est moins noble que le premier matériau.

L'expression « moins noble » est employée, dans ce document, pour désigner un matériau qui présente
- soit une qualité cristallographique moindre; dans ce cas par exemple, un matériau amorphe est moins noble qu'un matériau polycristallin, lui même moins noble qu'un matériau monocristallin ;
- soit un matériau obtenu par un procédé plus simple et/ou plus rapide dans sa mise en oeuvre ; selon ce critère le silicium monocristallin, par exemple, peut être considéré comme moins noble que le carbure de silicium monocristallin; on notera, en particulier, que le silicium monocristallin est moins cher que le carbure de silicium monocristallin;
- soit un matériau qui présente une qualité cristallographique moindre cumulée avec une procédure d'obtention par un procédé plus simple et/ou plus rapide dans sa mise en oeuvre, par exemple, un matériau obtenu par un procédé de tirage plus rapide engendre généralement comparativement plus de défauts; un tel matériau est également généralement moins cher et est considéré comme étant moins noble ; etc ;
- soit un matériau hybride comprenant une couche ou une zone de matériau présentant une qualité cristallographique moindre que le reste ; par exemple un substrat monocristallin recouvert d'une couche polycristalline.

Généralement, le matériau le moins noble sera le moins coûteux.

Le choix du matériau dit moins noble peut être large et varié, l'application visée et les technologies de fabrication correspondantes représentant les facteurs essentiels d'une restriction de ce choix.

Le choix du matériau moins noble est fonction de nombreux paramètres, et pour certaines applications, certains paramètres peuvent être privilégiés par rapport à d'autres. Si l'on privilégie certains paramètres, le choix portera sur un matériau monocristallin, alors que si l'on en privilégie d'autres, non.

Par exemple, dans le cas du transfert d'une couche de carbure de silicium, comme pour de nombreuses autres applications, certains des paramètres du deuxième matériau, c'est à dire celui du support, doivent être équivalents à ceux du premier matériau, ici le carbure de silicium monocristallin.

Aussi, dans le cas du transfert d'une couche de carbure de silicium monocristallin, qu'il provienne d'un substrat massif ou d'une couche épitaxiale, un candidat avantageux pour le support en matériau moins noble est un substrat de silicium, même monocristallin, dont le prix est assurément très compétitif en comparaison d'un substrat monocristallin de carbure de silicium.

En outre, dans le cas du transfert d'une couche de carbure de silicium monocristallin, le deuxième matériau, c'est à dire celui choisi pour le support doit généralement pouvoir supporter un procédé de traitement technologique de la couche de carbure de silicium exigeant, du fait que le carbure de silicium est un matériau présentant une grande inertie chimique, qu'il est difficilement usinable mécaniquement et chimiquement, etc. En particulier, le deuxième matériau devra, par exemple pour des étapes mettant en oeuvre une croissance épitaxiale de carbure de silicium, subir des traitements à haute température, ce qui nécessite que ce deuxième matériau ait une température de fusion suffisamment élevée, un coefficient de dilatation thermique adapté, ainsi qu'éventuellement une conductivité thermique appropriée. De même, si, en vue d'un dopage, des espèces atomiques sont implantées dans le carbure de silicium, le deuxième matériau pourra être amené à subir des recuits à haute température entraînant la même exigence par rapport au coefficient de dilatation thermique.

Par ailleurs, le matériau idéal pour être candidat en tant que deuxième matériau doit pouvoir remplacer le premier matériau, avec un minimum de modifications et un maximum de transparence pour l'utilisateur, dans les procédés généralement utilisés pour le traitement des substrats. Idéalement, ce deuxième matériau satisfait le plus possible au cahier des charges défini par des normes telles que les normes SEMI correspondant aux spécifications d'un substrat de silicium.

Au-delà de cette transparence pour l'utilisateur, selon un tel cahier des charges, des supports comportant, ou constitués, du deuxième matériau, et au delà de leur faible coût, ces supports doivent être compatibles avec les chaînes existantes de mise en forme et de traitement des substrats (polissage, nettoyage, chanfreinage, etc.). Idéalement, dans le cas d'un transfert d'une couche de silicium, un tel support doit pouvoir être traité sur des lignes de fabrication dédiées au silicium, qui par ailleurs mettent en oeuvre les techniques les plus développées à ce jour.

Ainsi, par exemple pour fabriquer des substrats de 300 mm de diamètre recouverts d'une couche de silicium, on peut utiliser une combinaison intéressante consistant à transférer une couche issue d'un substrat de silicium à faible taux de défauts, par exemple une couche épitaxiale de silicium ou une couche provenant d'un substrat obtenu par un tirage, tel qu'un tirage Czochralsky, à faible taux de défauts, sur un support de coût modéré issu notamment d'un tirage de lingots, à grande vitesse, dans des conditions non optimisées vis à vis de leurs densités de défauts cristallins. Dans ce cas, pour que des substrats de silicium de 300 mm de diamètre, soient acceptés dans une ligne de fabrication de microélectronique, ils doivent satisfaire à des conditions très exigeantes (pureté en contamination et pureté particulaire), et satisfaire aux différentes contraintes imposées par les différentes étapes (planéité pour les étapes de photolithographie, tenue mécanique pour les recuits rapides, réflectivité particulière pour ne perturber, ni la photolithographie, ni les divers capteurs de détection de substrats ou d'alignement équipant nombre d'équipements), etc.

En outre, ces supports comportant, ou constitués, du deuxième matériau, doivent avantageusement rester compatibles avec des opérations de transfert de couches, préférentiellement comprenant une étape de collage direct, et surtout rester compatibles avec le matériau de l'élément qu'ils sont destinés à supporter (On désigne dans ce document, par « collage direct » les techniques connues de l'homme du métier sous la terminologie angle-saxonne dite de « wafer bonding » ou de « direct bonding »).

Un aspect de cette compatibilité concerne notamment les coefficients de dilatation thermique. Une différence trop importante rend l'empilement des deux matériaux inutilisable puisque susceptible de casser dès lors que l'on appliquerait les traitements thermiques d'usage dans le domaine.

Dans la plupart des cas, et en particulier dans le cas de la fabrication de substrats de 300 mm de diamètre recouvert d'une couche monocristalline de silicium ou dans le cas de substrats recouverts d'une couche de carbure de silicium, un autre choix judicieux vis à vis de la transparence dans la ligne de traitement et de la compatibilité entre le support et la couche est d'utiliser le même matériau, mais sous forme polycristalline (le gain au plan économique se fait alors par rapport à un tirage du lingot et/ou de l'épitaxie).

Avantageusement, selon l'invention on réalise des substrats avec une ou plusieurs couche(s) monocristalline(s) sur un support polycristallin. Dans ce cas, la ou les couche(s) monocristalline(s) et le support polycristallin peuvent être par exemple constitués du même matériau.

Avantageusement, selon l'invention, on réalise des substrats avec une ou plusieurs couche(s) monocristalline(s) sur un support monocristallin lui même recouvert d'une couche de matériau polycristallin. Cette configuration présente au moins les deux avantages suivants :
- la couche de matériau polycristallin peut constituer une couche de piégeage d'impuretés métalliques (aussi appelé « gettering » par l'homme du métier), ce qui est très intéressant pour certaines applications, et
- la couche de matériau polycristallin peut constituer une zone de piégeage d'espèces dégazées par exemple, au cours d'éventuelles opérations de recuit.
   Ayant considéré ci-dessus la question du choix du matériau moins noble, considérons le choix du matériau amorphe.
   Ce choix peut également être large et varié.
   Avantageusement, l'interface entre les deux est électriquement conductrice (de manière à obtenir une meilleure conductivité électrique entre la couche utile et son support) et/ou thermiquement conductrice. Pour bon nombre d'applications, il n'est pas indispensable que cette interface soit exactement équivalente, en termes de performances, à un substrat massif monocristallin. C'est le cas notamment, lorsque pour certains dispositifs on souhaite juste réaliser une prise de contact en face arrière pour évacuer des charges parasites ou de la chaleur, par la face arrière.
   Dans d'autres cas, notamment dans le cas de la fabrication de substrats de SOI (SOI est l'acronyme de l'expression anglo-saxonne, « Silicium On Inusulator », c'est à dire du silicium sur isolant), l'interface n'est pas nécessairement électriquement conductrice.
   On connaît déjà, d'après le document US 5 298 449, un procédé de fabrication d'un substrat de type SOI, qui comprend des étapes de collage et de report de couche. Ce procédé vise à obtenir un substrat, dans lequel les deux couches de silicium, situées de part et d'autre d'une couche partielle d'isolant (SiO₂), peuvent être utilisées comme couches actives pour la fabrication de composants électroniques. De ce fait, on colle l'un avec l'autre, deux substrats de même et bonne qualité cristallographique, au moyen d'une couche de matériau amorphe.
   Ce procédé ne concerne absolument pas un procédé de fabrication visant à abaisser le coût de production d'un substrat et utilisant, pour ce faire, un support de moindre qualité, sur lequel on forme une couche de matériau amorphe, avant d'y reporter une couche active, qui seule sera utilisée pour la fabrication de composants électroniques.
   Selon un autre aspect, l'invention concerne un procédé dans lequel l'élément de matériau utile est collé sur la face d'un support, constituée d'un matériau polycristallin.
   Parmi les techniques de collage connues pour être compatibles avec les applications finales de type micro-electroniques, optique, électronique ou l'optoélectronique, les techniques les mieux adaptées sont les techniques de collage direct, dans lesquelles aucune colle n'est employée. Ces techniques sont relativement exigeantes en termes de rugosité et de planéité des surfaces à mettre en contact.
   Elles nécessitent généralement un polissage de ces surfaces juste avant collage ou plus tôt dans la fabrication des substrats. Pour réaliser un transfert sur un support monocristallin, de silicium par exemple, les techniques de polissage mises en oeuvre actuellement par l'ensemble des fabricants de substrats suffit, à condition qu'elles soient accompagnées de nettoyages suffisamment performants et que les opérations postérieures aux nettoyages soient réalisées dans un environnement suffisamment propre, pour éviter la contamination des surfaces à coller, par des particules, des hydrocarbures, etc.
   Par contre, lorsque l'une des surfaces de collage est constituée d'un matériau polycristallin, et surtout lorsque l'on souhaite avoir un collage direct, c'est à dire sans colle, ces techniques de collage direct deviennent délicates voire inefficaces.

Ces problèmes de collage direct se rencontrent que le matériau polycristallin soit obtenu par des techniques de dépôt de type « dépôt chimique en phase vapeur » (connu de l'homme du métier par l'acronyme « CVD » de l'expression anglo-saxonne « Chemical Vapor Deposition ») ou à partir d'un lingot de matériau polycristallin, ultérieurement découpé et transformé en substrats. Ces problèmes se rencontrent notamment, lorsque le matériau polycristallin est du silicium polycristallin.

Ces problèmes proviennent des irrégularités de la topologie des différents grains du matériau polycristallin. En effet, l'orientation des différents grains est imparfaite, le matériau présente des joints de grains plus ou moins développés, etc. Ainsi lorsque l'on poli des surfaces constituées d'un matériau polycristallin, on constate une anisotropie de la vitesse de polissage selon les différents grains, les joints de grains, etc. Ces irrégularités résultant du polissage de la surface s'amplifient dès lors que les techniques de polissage comportent une composante chimique. C'est également le cas lorsque différentes étapes de gravure, nettoyage, etc., interviennent dans la mise en forme des substrats ou la préparation, en vue d'un collage, de la surface constituée d'un matériau polycristallin.

Les difficultés à maîtriser le polissage de matériaux polycristallins pour une application au collage direct sont bien connues de l'homme du métier. De telles difficultés sont décrites, par exemple, dans le document Philips Journal of Research, Vol 49, 1995 (par exemple, pages 13 à 15 et 26 à 38). Les auteurs de ce document y expliquent les différentes classifications des techniques de polissage et leur impact sur la qualité d'un collage direct. Ces difficultés ont également été rapportées par certaines équipes dont le problème n'était pas tant de réaliser un collage direct sur un substrat polycristallin, que de joindre deux substrats de silicium en utilisant une couche intermédiaire de silicium polycristallin déposée sur l'un de ces substrats. Ces dernières difficultés sont notamment décrites dans les documents suivants :
- J. Jiao et al, Proc. SPIE - Int. Soc. Opt. Eng., 3223 (1997) 245 Micromachining and Microfabrication Process technology III. Austin TX USA, 29-30 sept 97 ;
- M. Salleh Isamil, Techn. Digest IEEE Solid state Sensor and Actuator Workshop (IEEE, New York NY USA, 1992), pp 66-89 (Hilton Head Island, SC, USA 22-25 June 92);
- W. G. Easter et al, Proceeding of the first international symposium on semiconductor wafer bonding, Science, Technology and Applications (Electrochem Society, Pennington, NJ USA), pp 223-229 : (Phoenix AZ, 13-18 oct 91);
- Y Inoue, IEEE Trans. Electr. devices (1995), 356 ; et
- K.N. Vinod, Transducers 97, 1997 International Conference on Solid State Sensors and Actuators (IEEE, New York NY USA, 1997), vol. , pp 653-656 (Chicago, IL, USA, 16-19 June 97).

Un autre but de l'invention est de proposer un procédé de fabrication de substrats, notamment pour l'optique, l'électronique ou l'optoélectronique, comprenant une opération de collage d'un élément de matériau utile sur une face d'un support, lorsqu'au moins l'un de ces deux éléments est polycristallin, au moins en surface de sa face destinée à être collée, résolvant les problèmes présentés ci-dessus et notamment ceux liés à la maîtrise du polissage.

Ce but est atteint, selon l'invention grâce à un procédé de fabrication de substrats, notamment pour l'optique, l'électronique ou l'optoélectronique, comprenant une opération de collage d'une couche d'un premier matériau sur une face d'un support, comportant un deuxième matériau, caractérisé par le fait que la couche ou le support comporte un matériau polycristallin au moins sur sa face destinée à être collée, et qu'il comprend en outre, préalablement à l'opération de collage, une opération de formation d'une couche de matériau amorphe, sur la face ou les faces comportant le matériau polycristallin.

Ce dernier procédé, conforme à l'invention, résout en particulier les problèmes de maîtrise du polissage. En effet, un matériau amorphe est par nature isotrope et absent d'irrégularités de taille de grains. On peut donc éventuellement, procéder à l'étape de collage, directement sur le matériau amorphe, que la couche de matériau amorphe soit réalisée par dépôt ou par amorphisation. Mais en outre, si un polissage est nécessaire, que la couche de matériau amorphe soit réalisée par dépôt ou par amorphisation, ce polissage est uniforme et permet d'obtenir une surface suffisamment plane pour réaliser un collage direct. L'utilisation d'un dépôt de matériau amorphe permet également par ailleurs de rattraper les irrégularités de topologie.

Avantageusement, le dépôt du matériau polycristallin et celui du matériau amorphe sont réalisés quasi-simultanément sans arrêter le dépôt, en jouant uniquement sur la température, par exemple en baissant celle utilisée pour obtenir le matériau amorphe par rapport à celle utilisée pour le dépôt de matériau polycristallin.

Le procédé selon l'invention est particulièrement avantageux dans le contexte de la réalisation de substrats à bas coût, dans lesquels par exemple on utilise pour le substrat support un matériau moins noble polycristallin que pour la couche utile.

En effet, les substrats en matériau polycristallin reviennent généralement moins cher que ceux en matériau monocristallin. Il est alors possible d'utiliser un substrat en matériau polycristallin comme support d'une couche ou d'un empilement de couches d'un ou plusieurs matériau(x) de meilleure qualité, par exemple de qualité monocristalline. Cette couche ou cet empilement de couches constitue la partie utile du substrat, c'est à dire que c'est cette partie qui sera utilisée, pour ses propriétés physiques, pour la réalisation de structures pour l'optique, l'électronique ou l'optoélectronique.

Pour ce type d'application, on peut utiliser n'importe quel procédé de transfert de couche faisant intervenir un collage de la couche sur un substrat. A titre d'exemple, on peut citer le procédé Smart-Cut^{®} dont un exemple de mise en oeuvre est décrit dans le brevet FR 2 681 472. Il est particulièrement avantageux d'utiliser le procédé Smart-Cut^{®} en combinaison avec la présente invention, du fait des possibilités de recyclage des substrats qu'il offre. En effet, grâce au procédé Smart-Cut^{®} , il est possible de transférer sur un substrat support, uniquement une couche pour former la partie utile, cette couche correspondant à une partie seulement d'un substrat source, le reste de ce substrat source pouvant être recyclé pour, par exemple, un éventuel prélèvement d'une nouvelle couche utile et ainsi de suite.

Le fait de pouvoir utiliser un support ayant un coût assez bas en combinaison avec le recyclage multiple d'un substrat source, offert par un procédé de type Smart-Cut^{®}, est particulièrement avantageux pour certaines applications. Parmi ces applications, on citera encore, par exemple, les cas de la fabrication de substrats de silicium monocristallin de 300mm de diamètre et de substrats de carbure de silicium monocristallin. Ces deux matériaux, le silicium monocristallin en grandes dimensions et le carbure de silicium monocristallin, sont en effet caractérisés par un coût de croissance de lingot élevé. Ce coût est d'autant plus élevé que l'on demande une qualité cristalline extrême puisque ce sont ces couches utiles qui supporteront les zones actives des futurs composants. Dans le cas de la fabrication de substrats de silicium monocristallin de 300 mm de diamètre par exemple, les conditions de croissance du silicium doivent être optimisées pour minimiser certains défauts cristallins.

Ainsi, dans le cas particulier du tirage de lingots, le tirage des lingots doit être effectué à des vitesses de tirage particulièrement lentes, il est donc coûteux. Pour les deux exemples de matériaux cités ci-dessus, il s'agit donc de réaliser des « quasi-substrats » ressemblant le plus possible à des substrats de silicium monocristallin ou de carbure de silicium monocristallin, mais dont le coût est minimisé.

Dans un autre cas particulier de ce qui a été présenté ci-dessus, la couche utile est une couche épitaxiale. Dans ce cas, ce type de couche, qui est connu pour mener à des qualités cristallines excellentes, présente un prix de revient particulièrement important. Cette couche épitaxiale peut alors elle aussi faire l'objet de prélèvements multiples (recyclages possibles basés par exemple sur un reconditionnement utilisant par exemple des gravures, polissage, nettoyage, recuit lissant sous hydrogène, etc., voire sur la régénération de la couche épitaxiale par une reprise d'épitaxie utilisant le même substrat).

Le procédé selon l'invention est également avantageusement appliqué à tout matériau dès lors qu'il y a génération de ce matériau avec un nouveau diamètre, plus important que ceux qui étaient obtenus jusqu'alors. En effet, il existe une période de temps pendant laquelle la disponibilité du matériau de bonne qualité à ce nouveau diamètre, associée à des technologies très avancées et des investissements importants, est limitée et donc coûteuse.

Le procédé selon l'invention est également avantageusement utilisé pour transférer des couches de silicium de haute qualité cristalline supportant une couche d'oxyde, sur un support comportant du matériau polycristallin au moins sur la face sur laquelle s'effectue le transfert, pour réaliser des structures SOI.

Les procédés selon l'invention comportent en outre avantageusement les caractéristiques suivantes prises isolément ou en combinaison :
- ils comprennent en outre une opération de polissage du matériau amorphe déposé sur le substrat, préalablement à l'opération de collage de l'élément de matériau utile ; au cours de cette opération de polissage, on retire entre 200 et 5000 Å, et préférentiellement 1000 Å, de matériau amorphe ;
- on forme un film de 1000 à 5000 Å, et préférentiellement 3000 Å de matériau amorphe, au cours de l'opération de dépôt ;
- ils comprennent une opération de traitement thermique de l'ensemble comprenant le support et l'élément de matériau utile, joints ensemble par l'intermédiaire du matériau amorphe (cette opération de traitement thermique est avantageusement menée à une température suffisante pour permettre une cristallisation au moins partielle du matériau amorphe) ;
- ils comprennent, postérieurement à l'opération de collage, une opération de détachement, d'une couche de matériau utile à partir d'une pièce constituée du matériau utile ;
- ils comprennent, préalablement à l'opération de collage, une opération d'implantation d'espèces atomiques sous la surface, destinée à être collée sur le support, de la pièce de matériau utile, à une profondeur d'implantation distribuée autour d'une certaine valeur, l'opération de détachement de la couche de matériau utile étant alors réalisée au niveau d'une profondeur de décollement située au voisinage de la profondeur d'implantation.

Avantageusement, un exemple de l'invention concerne aussi un substrat, notamment pour l'optique, l'électronique ou l'optoélectronique, comprenant
- un élément utile,
- un support présentant une face constituée d'un matériau polycristallin,
caractérisé par le fait qu'il comprend en outre, un matériau amorphe ou issu d'un matériau amorphe, électriquement conducteur, entre l'élément utile et la face constituée du matériau polycristallin.

Un autre exemple de l'invention concerne également un substrat, notamment pour l'optique, l'électronique ou l'optoélectronique, comprenant
- un élément constitué d'un premier matériau,
- un support constitué d'un deuxième matériau caractérisé par le fait que le deuxième matériau est moins noble que le premier et qu'il comprend en outre, un matériau amorphe, ou issu d'un matériau amorphe, électriquement conducteur, entre l'élément en premier matériau et le support en deuxième matériau.

Les applications des procédés selon l'invention peuvent viser aussi bien la fabrication de silicium sur isolant que la fabrication de quasi-substrats équivalents à des substrats massifs, notamment sans couche isolante intermédiaire.

D'autres buts, aspects et avantages de l'invention apparaîtront à la lecture de la description détaillée qui suit.

L'invention sera également mieux comprise à l'aide des références aux dessins, sur lesquels :
- les figures 1a à 1d représentent, schématiquement en coupe quatre exemples de substrats supports pour effectuer un transfert conforme à la présente invention ;
- la figure 2 représente, schématiquement en coupe, l'utilisation d'un substrat support de matériau polycristallin tel que celui de la figure 1a, pour la mise en oeuvre d'un premier exemple de procédé conforme à l'invention ;
- la figure 3 représente, schématiquement en coupe, l'utilisation d'un substrat support tel que celui représenté sur les figures 1a et 2, pour la mise en oeuvre d'un deuxième exemple de procédé conforme à l'invention ;
- la figure 4 représente, schématiquement en coupe, l'utilisation d'un substrat support tel que celui représenté sur les figures 1a, 2 et 3, pour la mise en oeuvre d'un troisième exemple de procédé conforme à l'invention ;
- la figure 5 représente, schématiquement en coupe, l'utilisation d'un substrat support tel que celui représenté sur les figures 1c et 1d, pour la mise en oeuvre d'un quatrième exemple de procédé conforme à l'invention ;
- la figure 6 représente, schématiquement en coupe, l'utilisation d'un substrat support tel que celui représenté sur les figures 1a et 1b, pour la mise en oeuvre d'un cinquième exemple de procédé conforme à l'invention ;
- la figure 7 représente, schématiquement en coupe, l'utilisation d'un substrat support tel que celui représenté sur les figures 1c et 1d, pour la mise en oeuvre d'un sixième exemple de procédé conforme à l'invention.

L'invention est décrite ci-dessous à l'aide de six modes particuliers, mais non limitatifs, de mise en oeuvre.

Les premier, deuxième, troisième et cinquième modes de mise en oeuvre concernent un collage menant à un transfert d'une couche utile, sur un substrat support polycristallin.

Les quatrième et sixième modes de mise en oeuvre concernent un collage menant à un transfert d'une couche utile, sur un substrat support comportant une couche de matériau polycristallin sur sa face destinée à recevoir la couche utile.

Selon le premier mode de mise en oeuvre, l'invention est employée pour réaliser le collage direct d'un élément de silicium monocristallin sur un support de silicium polycristallin.

Ce support 2 se présente par exemple sous la forme d'un disque de 200 mm de diamètre et de 725 microns d'épaisseur.

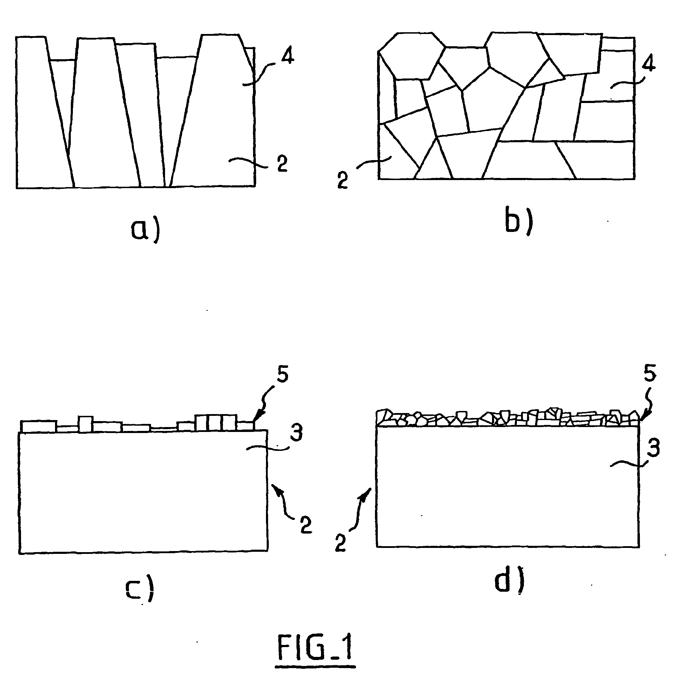

Ce support 2 est schématiquement représenté en coupe sur les figures 1a et 1b. Il présente des grains 4 monocristallins. Ces grains 4 monocristallins peuvent s'étendre sur toute l'épaisseur du support 2 comme par exemple dans un substrat à croissance colonaire (figure 1a). Mais le support 2 peut également être constitué par des grains 4 empilés de manière désordonnée les uns sur les autres et/ou les uns à coté des autres.

D'une manière totalement équivalente, à la place des supports 2 décrits ci-dessus en relation avec les figures 1a et 1b il est possible d'utiliser des supports 2 comportant une plaquette 3 recouverte d'une couche de matériau polycristallin. De tels supports 2 sont représentés sur les figures 1c à 1d. Là encore les supports 2 représentés sur les figures 1c et 1d présentent une couche de silicium polycristallin 5 constituée de grains 4 monocristallins pouvant s'étendre sur toute l'épaisseur de la couche de silicium polycristallin 5 (figure 1c), mais peuvent également être empilés de manière désordonnée les uns sur les autres et/ou les uns à coté des autres (figure 1d).

De tels supports 2 sont particulièrement avantageux pour absorber des espèces produites au cours d'un éventuel dégazage susceptible d'intervenir lors des divers traitements, et en particulier des traitements thermiques, du substrat obtenu après transfert de la couche utile sur le support 2.

Il est également possible d'utiliser des supports 2 constitués d'une plaquette 3 avec des composants, le tout étant recouvert d'une couche de silicium polycristallin 5, ou encore constitués d'une plaquette 3 de matériau amorphe également recouverte d'une couche de silicium polycristallin 5, ou bien encore constitués d'une plaquette 3 d'un matériau choisi pour sa très bonne conductivité thermique, et/ou sa transparence à la lumière, et/ou encore une autre propriété physique, elle aussi recouverte d'une couche de silicium polycristallin 5.

Dans chaque cas la couche de silicium polycristallin 5 a avantageusement 500 à plusieurs milliers d'angstroems d'épaisseur (10 angströms = 1 nanomètre) pour la microélectronique et plusieurs dizaines de microns pour les applications photovoltaïques.

On notera que bien que le support 2 soit poli, la surface est généralement irrégulière comme dans tous les cas illustrés par la figure 1.

Typiquement, lorsque le support 2 est en silicium polycristallin massif (figures 1a et 1b), il présente, après polissage, une topologie de surface avec des irrégularités en altitude qui peuvent s'étendre, dans les pires cas, sur une plage de 500 Å (50mm)

Mais il suffit de moins de quelques dizaines d'angstroems pour nuire au collage direct

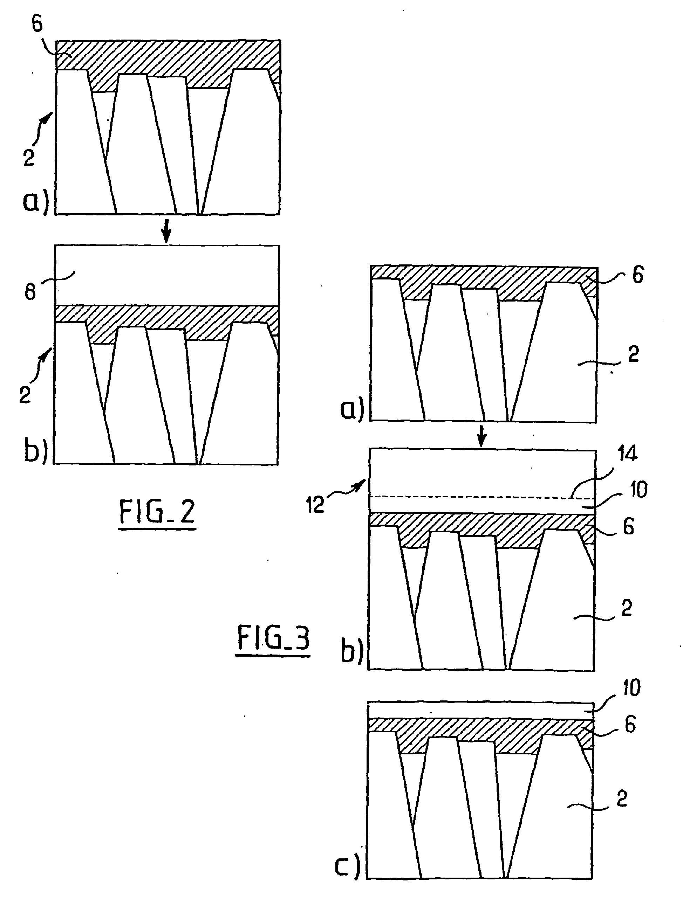

Conformément au procédé selon l'invention, on dépose alors sur le support 2 poli, une couche de silicium amorphe 6 de 3000 Å (300 nm) d'épaisseur, par une technique connue, décrite par exemple dans le document Silicon Processing for the VLSI Era, Vol 1, Process technology; S. Wolf and R.N. Tauber, Lattice press, chapitre 6 (figure 2a).

On effectue ensuite un léger polissage mécano-chimique sur la surface de la couche de silicium amorphe 6, pour retirer environ 1 000 Å (100nm) de silicium amorphe.

Un substrat 8 de silicium monocristallin est alors mis en contact avec la surface libre polie de la couche de silicium amorphe 6, pour former une liaison, par les techniques connues de collage direct (figure 2b). On se référera, pour ces techniques de collage, par exemple, à l'ouvrage de Q.-Y Tong et U. Gösele, Semiconductor Wafer Bonding, Science and technology, The Electrochemeical Society Series, Wiley Inter-Science, New-York 1999.

Le tableau 1 présente des résultats de collage entre un support 2 et un substrat 8 de silicium monocristallin, sans ou avec une couche de silicium amorphe 6 entre les deux.

**Tableau 1**

| | *SANS* | *AVEC* | |
|---|---|---|---|
| | dépôt de silicium amorphe | dépôt de silicium amorphe | |
| | | Sans repolissage de la couche de silicium amorphe 6 | Avec repolissage de la couche de silicium amorphe 6 |
| Silicium polycristallin déjà poli avec un certain degré de qualité | - | + | ++ |
| Silicium poly-cristallin Grossièrement poli | -- | - | + + |

Codes sur la qualité du collage, utilisés dans le tableau 1 :
- - Collage difficile ou partiel avec de nombreuses zones non collées.
- Collage partiel, quelques zones non-collées.
+ Collage total, peu de défauts de collage observés en transmission infra rouge.
+ + Collage total, pas de défaut de collage observé en transmission infra rouge.

On constate d'après le tableau 1 que le collage n'est réellement satisfaisant que lorsqu'une couche de silicium amorphe 6 est déposée sur le support 2 de silicium polycristallin. Le collage est encore meilleur si l'on réalise un polissage de la couche de silicium amorphe 6, telle que dans le mode de mise en oeuvre décrit en relation avec la figure 2.

Selon le deuxième mode de mise en oeuvre de l'invention illustré par la figure 3, on réalise le transfert d'une couche de silicium monocristallin 10, à partir d'un substrat source 12 monocristallin.

Comme pour le mode de mise en oeuvre décrit ci-dessus, un support 2 de silicium polycristallin, est poli. Puis, une couche de silicium amorphe 6 de 3000 Å (300nm) d'épaisseur est déposée sur le support 2. Un léger polissage mécano-chimique de la surface libre de cette couche de silicium amorphe 6 est opéré, retirant environ 500 Å (50 nm) de silicium amorphe (figure 3a).

Par ailleurs, un substrat source 12 monocristallin subit une implantation d'espèces atomiques, par exemple d'hydrogène, conformément aux procédés décrits dans le document FR 2 681 472, ou à l'une des variantes de ces procédés.

Par implantation d'espèces atomiques, on entend tout bombardement d'espèces atomiques, moléculaires, ou ioniques, susceptible d'introduire ces espèces dans un matériau, avec un maximum de concentration de ces espèces dans ce matériau, ce maximum étant situé à une profondeur déterminée par rapport à la surface bombardée. Les espèces atomiques moléculaires ou ioniques sont introduites dans le matériau avec une énergie également distribuée autour d'un maximum. L'implantation des espèces atomiques dans le matériau peut être réalisée grâce à un implanteur par faisceau d'ions, un implanteur par immersion dans un plasma, etc.

Cette implantation génère une zone de fragilisation 14.

Le substrat source 12 ainsi fragilisé est ensuite mis en contact avec la surface libre et polie, de la couche de silicium amorphe 6, pour former une liaison, par collage direct (figure 3b). on applique ensuite à tout ou partie de l'ensemble support 2 - substrat source 12 une action apte à engendrer un détachement de la couche de silicium monocristallin 10 du substrat source 12 au niveau de la zone de fragilisation 14.

D'une manière générale, cette action peut correspondre à l'application de contraintes mécaniques (cisaillement, traction, compression, ultrasons, etc.), de contraintes ayant pour origine une énergie électrique (application d'un champ électrostatique ou électromagnétique), de contraintes ayant pour origine une énergie thermique (radiation, convection, conduction, augmentation de la pression dans les microcavités, etc.), etc. Cela peut consister également à diriger un jet de fluide (liquide ou gazeux) continu ou temporellement variable, au niveau de l'interface de décollement couche utile 10/substrat source 12. Les contraintes ayant pour origine une énergie thermique en particulier peuvent dériver de l'application d'un champ électromagnétique, d'un faisceau d'électrons, d'un chauffage thermoélectrique, d'un fluide cryogénique, d'un liquide super-refroidi, etc.

La couche de silicium monocristallin 10 est ainsi transférée sur le support 2 par collage direct via la couche de silicium amorphe 6.

En variante de ce mode de réalisation, d'autres techniques d'implantation .(par exemple, implantation par plasma), et/ou d'autres techniques de transfert d'une couche mince peuvent être utilisées. L'implantation peut également être effectuée dans une zone mécaniquement fragilisée, par exemple une zone poreuse.

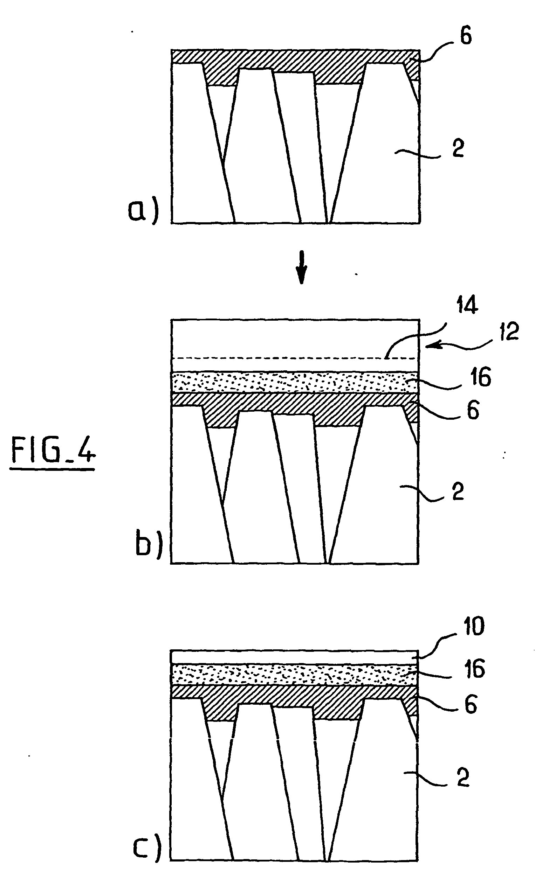

Selon le troisième mode de mise en oeuvre de l'invention, illustré par la figure 4, on réalise un substrat de silicium sur isolant. Selon ce mode de mise en oeuvre, on prépare un support 2 de silicium polycristallin recouvert d'une couche de silicium amorphe 6 (figure 4a), de la même manière que ce qui a été décrit en relation avec les deux modes de mise en oeuvre exposés ci-dessus.

On crée également sur un substrat 12 une couche d'oxyde thermique 16 par une technique connue de l'homme du métier. On implante aussi, comme indiqué dans le deuxième mode de mise en oeuvre, des espèces atomiques dans le substrat source 12 de silicium monocristallin, pour créer une zone de fragilisation 14.

Le substrat 12 est ensuite mis en contact du support 2, couche d'oxyde de silicium 16 contre couche de silicium amorphe 6 (figure 4b).

Une action apte à engendrer le détachement de la couche d'oxyde 16 et de la couche de silicium monocristallin 10, à partir du substrat source 12 est alors appliquée, de manière analogue à ce qui a été décrit en relation avec le deuxième mode de réalisation, afin de former ainsi un substrat de silicium sur isolant. Ce substrat de silicium sur isolant est constitué d'un empilement de couches successives : un support de silicium polycristallin 2, une couche de silicium amorphe 6, une couche d'oxyde de silicium 16 et une couche de silicium monocristallin 10.

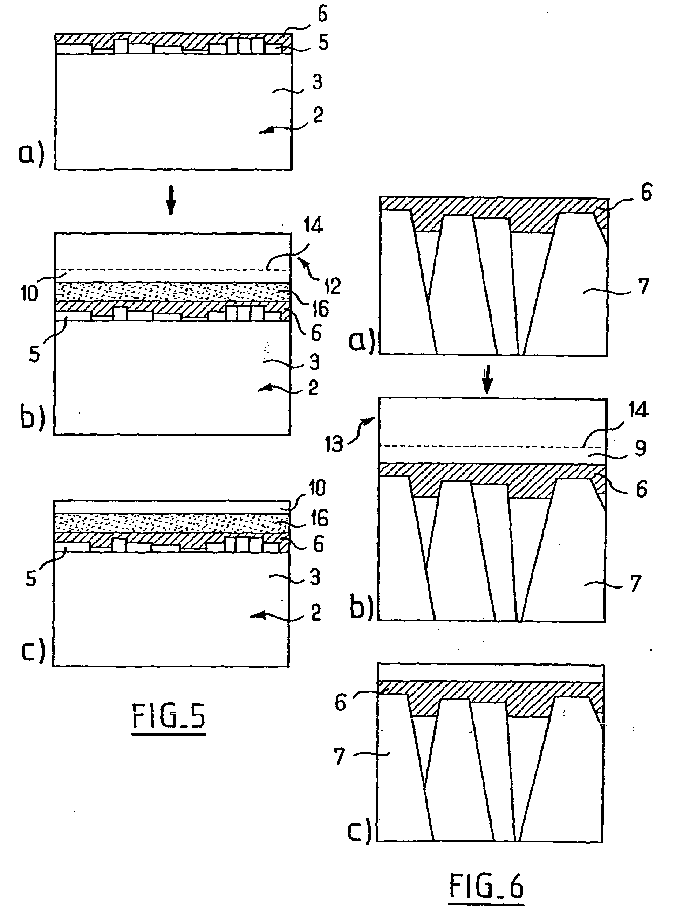

Selon le quatrième mode de mise en oeuvre de l'invention, illustré par la figure 5, on réalise également un substrat de silicium sur isolant. Pour ce faire, on assemble une plaquette 3 de silicium avec un substrat 12 de silicium comportant une couche d'oxyde de silicium 16 et implanté comme décrit ci-dessus, pour former une zone de fragilisation 14. Mais dans ce cas, la couche d'oxyde de silicium 16 est trop mince (typiquement lorsqu'elle fait moins de 1 000 Å (100nm) d'épaisseur) pour absorber les espèces dégazées au cours des opérations ultérieures et qui nuisent à la qualité du collage. Pour éviter la formation de bulles à l'interface de collage consécutives à ce dégazage, on réalise, sur la plaquette 3, une couche de silicium polycristallin 5 destinée à absorber les espèces dégazées. Puis, comme il n'existe pas encore de techniques de polissage du matériau polycristallin permettant d'obtenir un collage satisfaisant, pour palier les inconvénients du matériau polycristallin en termes de rugosité de surface, on dépose une couche de matériau amorphe 6, sur le matériau polycristallin (fig. 5a). On notera que si les techniques évoluent favorablement, le dépôt de la couche de matériau amorphe 6 pourrait devenir facultatif. Pour l'exemple de mode de mise en oeuvre du procédé selon l'invention présenté ici, le matériau polycristallin 5 est avantageusement du silicium polycristallin et le matériau amorphe 6 est avantageusement du silicium amorphe.

Le support 2 constitué de la plaquette 3 et des couches de silicium polycristallin 5 et amorphe 6, et le substrat 12 de silicium comportant la couche d'oxyde de silicium 16 sont mis en contact et assemblés par collage direct (fig. 5b).

Une action apte à engendrer le détachement de la couche d'oxyde 16 et de la couche de silicium monocristallin 10, à partir du substrat source12 est alors appliquée, de manière analogue à ce qui a été décrit en relation avec les deuxième et troisième modes de réalisation, afin former ainsi un substrat de silicium sur isolant (fig. 5c).

Le résultat du procédé selon l'invention, selon le quatrième mode de mise en oeuvre, est un substrat de silicium sur isolant comportant empilé successivement, une plaquette 3 de silicium monocristallin recouverte d'une couche de silicium polycristallin 5, recouverte elle même d'une couche de silicium amorphe 6, puis une couche d'oxyde de silicium 10 et une couche de silicium monocristallin 10.

Selon une autre variante, la couche de silicium polycristallin 5, peut être déposée sur l'oxyde 16 avant réalisation d'une couche de silicium amorphe, plutôt que sur le support 2. Elle peut aussi être déposée à la fois sur le support 2 et sur la couche d'oxyde 16.

Selon une variante des troisième et quatrième modes de mise en oeuvre, une couche d'oxyde peut être formée sur le support 2, par exemple sur la couche de matériau amorphe 6. Cette couche d'oxyde peut remplacer la couche d'oxyde 16 recouvrant la couche de matériau monocristallin 10, mais elle peut également être prévue en addition de la couche d'oxyde 16 recouvrant la couche de matériau monocristallin 10.

Selon une variante de ces troisième et quatrième modes de mise en oeuvre, le silicium peut être remplacé par du carbure de silicium.

De plus, d'une manière générale, la (ou les) couche(s) d'oxyde peut (peuvent) être remplacée(s) par un autre isolant (un nitrure par exemple).

Selon le cinquième mode de mise en oeuvre de l'invention, illustré par la figure 6, on réalise un substrat comportant une couche utile de carbure de silicium monocristallin 9 sur du carbure de silicium polycristallin. Pour ce faire, on prépare d'une part, un support 7 de carbure de silicium polycristallin et, d'autre part, un substrat source de carbure de silicium monocristallin 13 comportant une zone de fragilisation 14 réalisée de manière à ce qui a été décrit plus haut. Ensuite, comme il n'existe pas encore de techniques de polissage du matériau polycristallin permettant d'obtenir un collage satisfaisant, pour palier les inconvénients du matériau polycristallin en termes de rugosité de surface, on dépose une couche de matériau amorphe 6, sur le support de carbure de silicium polycristallin 7 (Fig. 6a). On notera que le carbure de silicium polycristallin peut avantageusement absorber les espèces dégazées comme expliqué ci-dessus. On notera également ici encore que si les techniques évoluent favorablement, le dépôt de la couche de matériau amorphe 6 pourrait devenir facultatif. Pour l'exemple de mode de mise en oeuvre du procédé selon l'invention présenté ici, le matériau amorphe 6 est avantageusement du silicium amorphe.

Le support 7 et le substrat 13 sont mis en contact et assemblés par collage direct (fig. 6b).

Une action apte à engendrer le détachement de la couche de carbure de silicium monocristallin 9, à partir du substrat source de carbure de silicium 13 est alors appliquée, de manière analogue à ce qui a été décrit en relation avec les deuxième, troisième et quatrième modes de réalisation, afin de former ainsi un substrat comportant une couche utile de carbure de silicium monocristallin 9 sur un support de carbure de silicium polycristallin 7 (fig. 6c).

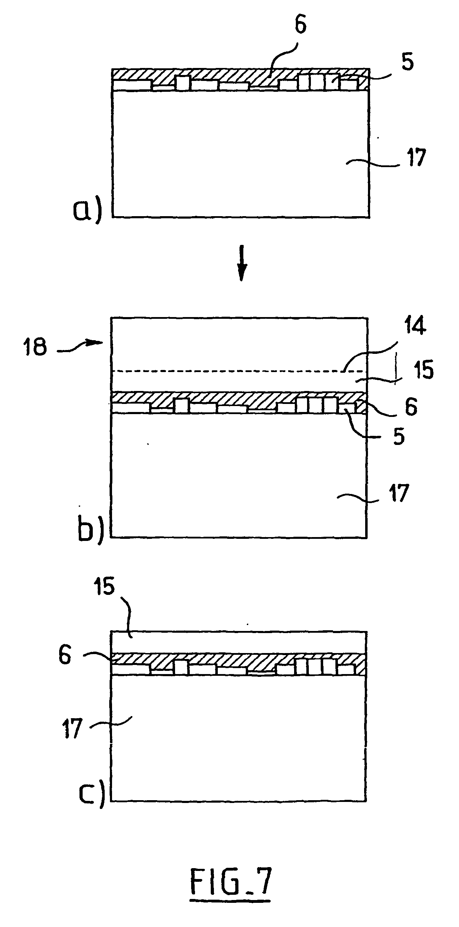

Selon le sixième mode de mise en oeuvre de l'invention, illustré par la figure 7, on réalise un substrat comportant une couche utile de silicium monocristallin de bonne qualité 15, c'est à dire une qualité correspondant à un faible taux de défauts, sur un support de silicium monocristallin de moins bonne qualité 17. Cette qualité correspond par exemple à un matériau obtenu par épitaxie, à un matériau dit « cristal parfait » ou tout autre matériau qui dans l'avenir correspondra à une qualité optimisée par rapport à ce qui se fait au moment du dépôt de cette demande de brevet. Cette qualité correspond a un matériau qui est utilisé pour ses propriétés électroniques et/ou optiques, etc., cette qualité ayant été optimisée à cette fin. Un substrat source de silicium de bonne qualité 18 préparé avec une zone de fragilisation 14 réalisée de manière analogue à ce qui a été décrit plus haut.

Pour pallier les inconvénients de la formation de bulles dues aux produits de dégazage, on réalise avantageusement, sur le support 17 de silicium monocristallin de moins bonne qualité, une couche de silicium polycristallin 5 destinée à absorber les espèces dégazées. Puis, comme il n'existe pas encore de techniques de polissage du matériau polycristallin permettant d'obtenir un collage satisfaisant, pour palier les inconvénients du matériau polycristallin en termes de rugosité de surface, on dépose une couche de matériau amorphe 6, sur le matériau polycristallin (fig. 7a). On notera que si les techniques évoluent favorablement, le dépôt de la couche de matériau amorphe 6 pourrait devenir facultatif. Pour l'exemple de mode de mise en oeuvre du procédé selon l'invention présenté ici, le matériau amorphe 6 est avantageusement du silicium amorphe.

Le support 17 et le substrat 18 sont mis en contact et assemblés par collage direct (fig. 7b).

Une action apte à engendrer le détachement de la couche de silicium monocristallin de bonne qualité 15, à partir du substrat source de silicium de bonne qualité 18 est alors appliquée, de manière analogue à ce qui a été décrit en relation avec les deuxième, troisième, quatrième et cinquième modes de réalisation, afin de former ainsi un substrat comportant une couche utile de silicium monocristallin de bonne qualité 15 sur un support de silicium monocristallin de moins bonne qualité 17 (fig. 6c).

De nombreuses variantes aux modes de mise en en oeuvre de l'invention décrits ci-dessus peuvent être envisagées.

Ainsi les supports 2, 7, 17 munis d'une couche de matériau amorphe 6 peuvent subir, préalablement à l'opération de collage avec le substrat 8 ou un substrat source 12, 13, 18 divers traitements classiques et connus dans les techniques relatives au silicium amorphe, notamment hydrogénation, dégazage, et divers traitements thermiques tels que, par exemple un traitement thermique de densification.

Avantageusement la couche de silicium amorphe peut être dopée pour améliorer les performances électriques.

L'ensemble constitué de la couche utile et de son support peut aussi subir un recuit, après assemblage, au cours duquel, il peut y avoir une cristallisation au moins partielle de la couche de matériau amorphe 6.

Par ailleurs, dans les exemples de mise en oeuvre décrits ci-dessus, la couche de matériau amorphe 6 est en silicium amorphe, mais de nombreux autres matériaux amorphes peuvent être envisagés pour la mise en oeuvre des procédés conformes à la présente invention. On citera, à titre d'exemple les siliciures, tels que du siliciure de titane, TiSi₂, ou du siliciure de palladium, Pd₂Si.

De même, ce qui a été décrit ci-dessus en relation avec des applications destinées à fabriquer des substrats comportant une couche utile de carbure de silicium, ou des substrats de silicium de 300 mm de diamètre peut être généralisé à de nombreux autres matériaux sans sortir du cadre de l'invention.

En particulier, l'invention est avantageuse dans tous les cas où l'on ne sait pas encore réaliser un polissage permettant d'obtenir une qualité de surface d'un matériau polycristallin suffisante pour réaliser un collage direct.

Enfin, toutes les caractéristiques du procédé selon l'invention décrites ci-dessus peuvent être prises indépendamment ou en combinaison, pour définir de nouveaux modes de mise en oeuvre conforme à l'invention.

## Revendications

1. Procédé de fabrication de substrats, notamment pour l'optique, l'électronique ou l'optoélectronique, comprenant une opération de collage d'une couche (10,16) sur un support (2), **caractérisé par le fait que** la couche (10, 16) ou/et le support (2) comportent un matériau polycristallin au moins au niveau de sa face ou de leurs faces de collage, et **par le fait que** le procédé comprend en outre, préalablement à l'opération de collage, une opération de formation d'une couche de matériau amorphe (6) sur la ou au moins une face de collage qui comporte le matériau polycristallin.

2. Procédé selon la revendication 1, **caractérisé par le fait que** la formation de la couche de matériau amorphe (6) est réalisée par dépôt.

3. Procédé selon la revendication 1, **caractérisé par le fait que** la formation de la couche de matériau amorphe (6) est réalisée par amorphisation.

4. Procédé selon l'une des revendications précédentes, **caractérisé par le fait que** le matériau amorphe (6) est du silicium amorphe.

5. Procédé selon l'une des revendications précédentes, **caractérisé par le fait qu'**il comprend en outre une opération de Polissage du matériau amorphe (6) déposé sur le support (2), préalablement à l'opération de collage.

6. Procédé selon la revendication 5, **caractérisé par le fait que** l'on retire entre 20 et 500 nm, et préférentiellement 100 nm, de matériau amorphe (6) au cours de l'opération de polissage.

7. Procédé selon l'une des revendications précédentes, **caractérisé par le fait qu'**il comprend en outre une opération de traitement thermique de l'ensemble comprenant le support (2) et la couche (10, 16) réunis par l'intermédiaire du matériau amorphe (6).

8. Procédé selon la revendication 7, **caractérisé par le fait que** l'opération de traitement thermique est menée à une température qui permet d'obtenir une cristallisation au moins partielle du matériau amorphe (6).

9. Procédé selon l'une des revendications précédentes, **caractérisé par le fait qu'**il comprend, postérieurement à l'opération de collage, une opération de détachement, d'une couche (10) à partir d'une pièce (12).

10. Procédé selon la revendication 9. **caractérisé par le fait qu'**il comprend, préalablement à l'opération de collage, une opération d'implantation d'espèces atomiques sous la surface, destinée à être collée sur le support (2), de la pièce (12), à une profondeur d'implantation distribuée autour d'une certaine profondeur, l'opération de détachement de la couche (10) étant alors réalisée au niveau d'une profondeur de décollement (14) située au voisinage de la profondeur d'implantation.

11. Procédé selon l'une des revendications précédentes, **caractérisé par le fait que** le support (2) comprend un matériau monocristallin recouvert d'une couche de matériau polycristallin.

12. Procédé selon l'une des revendications 1 à 10, **caractérisé par le fait que** le support (2) est constitué par du silicium polycristallin.

13. Procédé selon l'une des revendications 1 à 10, **caractérisé par le fait que** le support (2) est constitué par du carbure de silicium polycristallin.

14. Procédé selon l'une des revendications précédentes, **caractérisé par le fait que** la couche (10) est constitué par du silicium monocristallin.

15. Procédé selon l'une des revendications 1 à 13, **caractérisé par le fait que** la couche (10) est constitué par du carbure de silicium monocristallin.

16. Procédé selon l'une des revendications précédentes, **caractérisé par le fait que** la couche (10) comporte une couche de matériau monocristallin (10) et une couche d'isolant (16), tel qu'un oxyde.

17. Procédé selon l'une des revendications 1 à 10 **caractérisé par le fait que** le support (2) est constitué par du silicium monocristallin.

18. Procédé selon l'une de revendications précédentes, **caractérisé par le fait que** le support (2) comporte une couche d'isolant tel qu'un oxyde.

19. Procédé selon l'une des revendications précédentes, **caractérisé par le fait que** le matériau amorphe (6) est électriquement conducteur.

20. Procédé selon l'une des revendications précédentes, **caractérisé par le fait que** la couche de matériau amorphe présente une épaisseur de 100 à 500 nm, préférentiellement 300 nm.

## Claims

1. A method of fabricating substrates, in particular for use in optics, electronics or optoelectronics, including an operation of bonding a layer (10, 16) on a support (2), **characterized in that** the layer (10, 16) and/or the support (2) include(s) a polycrystalline material at least on their/its face(s) intended to be bonded and **in that** the method further includes, prior to bonding, forming an amorphous material layer (6) on the, or at least one of the bonding faces including the polycrystalline material.

2. A method according to claim 1, **characterized in that** the amorphous material layer (6) is formed by a deposition process.

3. A method according to claim 1, **characterized in that** the amorphous material layer (6) is formed by an amorphization process.

4. A method according to any preceding claim, **characterized in that** the amorphous material (6) is amorphous silicon.

5. A method according to any preceding claim, **characterized in that** it further includes polishing the amorphous material (6) deposited on the support (2) before bonding.

6. A method according to claim 5, **characterized in that** polishing removes from 20 to 500 nm, and preferably 100 nm, of amorphous material (6).

7. A method according to any preceding claim, **characterized in that** it further includes heat treating the combination of the support (2) and the layer (10, 16) joined together by the amorphous material (6).

8. A method according to claim 7, **characterized in that** the heat treatment is conducted at a temperature which allows the crystallization of the amorphous material (6) at least partly.

9. A method according to any preceding claim, **characterized in that** it includes, after bonding, detaching a layer (10) from a part (12).

10. A method according to claim 9, **characterized in that** it includes, before bonding, implanting atomic species under the surface intended to be bonded to the support (2) of the part (12) at an implantation depth distributed around a particular depth, the layer (10) then being detached at a detachment depth (14) in the vicinity of the implantation depth.

11. A method according to any preceding claim, **characterized in that** the support (2) includes a monocrystalline material covered with a layer of polycrystalline material.

12. A method according to any of claims 1 to 10, **characterized in that** the support (2) is made of polycrystalline silicon.

13. A method according to any of claims 1 to 10, **characterized in that** the support (2) is made of polycrystalline silicon carbide.

14. A method according to any preceding claim, **characterized in that** the layer (10) is made of monocrystalline silicon.

15. A method according to any of claims 1 to 13, **characterized in that** the layer (10) is made of monocrystalline silicon carbide.

16. A method according to any preceding claim, **characterized in that** the layer (10) includes a monocrystalline material layer (10) and an insulator material layer (16) such as an oxide layer.

17. A method according to any of claims 1 to 10, **characterized in that** the support (2) is made of monocrystalline silicon.

18. A method according to any preceding claim,
**characterized in that** the support (2) includes an insulator layer such as an oxide layer.

19. A method according to any preceding claim, **characterized in that** the amorphous material (6) is electrically conductive.

20. A method according to any preceding claim, **characterized in that** the film of amorphous material is from 100 to 500 nm thick, and preferably 300 nm thick.

## Patentansprüche

1. Verfahren zur Herstellung von Substraten, insbesondere für die Optik, Elektronik oder Optoelektronik, das einen Vorgang des Klebens einer Schicht (10, 16) auf einen Träger (2) umfaßt, **dadurch gekennzeichnet, daß** die Schicht (10, 16) oder/und der Träger (2) wenigstens im Bereich ihrer oder seiner Klebeseite, bzw. Klebeseiten, ein polykristallines Material umfaßt/umfassen, und **dadurch**, daß das Verfahren außerdem vor dem Klebevorgang einen Vorgang zur Ausbildung einer Schicht aus amorphem Material (6) auf der oder wenigstens einer das polykristalline Material aufweisenden Klebeseite umfaßt.

2. Verfahren nach Anspruch 1, **dadurch gekennzeichnet, daß** die Ausbildung der Schicht aus amorphem Material (6) durch Abscheiden realisiert wird.

3. Verfahren nach Anspruch 1, **dadurch gekennzeichnet, daß** die Ausbildung der Schicht aus amorphem Material (6) durch Amorphisieren realisiert wird.

4. Verfahren nach einem der vorhergehenden Ansprüche, **dadurch gekennzeichnet, daß** das amorphe Material (6) amorphes Silicium ist.

5. Verfahren nach einem der vorhergehenden Ansprüche, **dadurch gekennzeichnet, daß** es vor dem Klebevorgang außerdem einen Vorgang des Polierens des auf den Träger (2) abgeschiedenen amorphen Materials (6) umfaßt.

6. Verfahren nach Anspruch 5, **dadurch gekennzeichnet, daß** im Verlauf des Poliervorgangs vom amorphen Material (6) zwischen 20 und 500 nm und vorzugsweise 100 nm abgetragen werden.

7. Verfahren nach einem der vorhergehenden Ansprüche, **dadurch gekennzeichnet, daß** es außerdem einen Vorgang der Wärmebehandlung der Einheit umfaßt, die den Träger (2) und die Schicht (10, 16) umfaßt, die mittels des amorphen Materials (6) verbunden sind.

8. Verfahren nach Anspruch 7, **dadurch gekennzeichnet, daß** der Wärmebehandlungsvorgang bei einer Temperatur ausgeführt wird, die es gestattet, eine wenigstens teilweise Kristallisation des amorphen Materials (6) zu erhalten.

9. Verfahren nach einem der vorhergehenden Ansprüche, **dadurch gekennzeichnet, daß** es nach dem Klebevorgang einen Vorgang des Ablösens einer Schicht (10) von einem Teil (12) umfaßt.

10. Verfahren nach Anspruch 9, **dadurch gekennzeichnet, daß** es vor dem Klebevorgang einen Vorgang der Implantation von Atomsorten unter der Oberfläche des Teils (12), die dafür vorgesehen ist, auf den Träger (2) geklebt zu werden, umfaßt, und dies in einer Implantationstiefe, die um eine bestimmte Tiefe herum verteilt ist, wobei der Vorgang des Ablösens der Schicht (10) dann im Bereich einer Ablösetiefe (14) ausgeführt wird, die benachbart zur Implantationstiefe ist.

11. Verfahren nach einem der vorhergehenden Ansprüche, **dadurch gekennzeichnet, daß** der Träger (2) ein monokristallines Material umfaßt, das mit einer Schicht aus polykristallinem Material bedeckt ist.

12. Verfahren nach einem der Ansprüche 1 bis 10, **dadurch gekennzeichnet, daß** der Träger (2) aus polykristallinem Silicium besteht.

13. Verfahren nach einem der Ansprüche 1 bis 10, **dadurch gekennzeichnet, daß** der Träger (2) aus polykristallinem Siliciumkohlenstoff besteht.

14. Verfahren nach einem der vorhergehenden Ansprüche, **dadurch gekennzeichnet, daß** die Schicht (10) aus monokristallinem Silicium besteht.

15. Verfahren nach einem der Ansprüche 1 bis 13, **dadurch gekennzeichnet, daß** die Schicht (10) aus monokristallinem Siliciumkohlenstoff besteht.

16. Verfahren nach einem der vorhergehenden Ansprüche, **dadurch gekennzeichnet, daß** die Schicht (10) eine Schicht aus einem monokristallinen Material (10) und eine isolierende Schicht (16), wie etwa ein Oxid, umfaßt.

17. Verfahren nach einem der Ansprüche 1 bis 10, **dadurch gekennzeichnet, daß** der Träger (2) aus monokristallinem Silicium besteht.

18. Verfahren nach einem der vorhergehenden Ansprüche, **dadurch gekennzeichnet, daß** der Träger (2) eine isolierende Schicht, wie etwa ein Oxid, umfaßt.

19. Verfahren nach einem der vorhergehenden Ansprüche, **dadurch gekennzeichnet, daß** das amorphe Material (6) elektrisch leitend ist.

20. Verfahren nach einem der vorhergehenden Ansprüche, **dadurch gekennzeichnet, daß** die Schicht aus amorphem Material eine Dicke von 100 bis 500 nm und vorzugsweise von 300 nm hat.
